# EUROPEAN PATENT SPECIFICATION

(11) **EP 0 338 200 B1**
(45) Date of publication and mention of the grant of the patent: **26.06.1996**
(21) Application number: 89102186.7
(22) Date of filing: 09.02.1989
(51) Int. Cl.: G02B 7/36, G03F 7/20

(54) **Method and apparatus for characterization of optical systems**
Verfahren und Gerät zur Charakterisierung von optischen Systemen
Méthode et appareil pour caractériser des systèmes optiques

(30) Priority: 31.03.1988 CA 563039
(43) Date of publication of application: 25.10.1989
(73) Proprietor: International Business Machines Corporation, Armonk, N.Y. 10504 (US)
(72) Inventor: Barr, Roger Lawrence, Colchester Vermont 05446 (US); Cote, Marc, Essex Junction Vermont 05452 (US); Farrell, Timothy Richard, South Burlington Vermont 05403 (US); Sisler, Sharon Breed, Waterbury Center Vermont 05677 (US)
(74) Representative: Lindner-Vogt, Karin, Dipl.-Phys.

(56) References cited:
- EP-A- 0 170 013
- US-A- 4 435 079
- RESEARCH DISCLOSURES, no. 264, April 1986, disclosure no. 26433; "Focus matrixtechnique for a projection printer"
- IBM TECHNICAL DISCLOSURE BULLETIN, vol. 30, no. 2, July 1987, pages 516-518, Armonk, New York, US; "Method for measuring semiconductor lithographic tool focus and exposure"

## Description

This invention relates generally to a method and apparatus for quantitatively determining various characteristics of lenses or optical systems, and more particularly to a method and apparatus for quantitatively determining such characteristics of a lens or optical system as focal position, focus surface or curvature of the system, and relative depth of focus throughout the field of the system. The method and apparatus are particularly useful in optical systems used in photo microlithography for the production of semiconductor integrated circuit chips and wafers, although the use is not so limited to these systems.

In photo microlithography, a lens system is used in conjunction with a reticle or mask having the desired object pattern formed thereon corresponding to the object pattern which is to be exposed on the wafer surface. In some cases a single object pattern is utilized to imagewise expose the entire wafer, whereas in other cases a step and repeat technique is utilized to imagewise expose the wafer in successive steps. In either case, it is necessary to have the entire image as precisely in focus as possible on the wafer in order to achieve acceptable line patterns which will be properly developed and crisply delineated by subsequent development processing techniques.

As smaller and smaller line sizes are being used, the criticality of accurate focusing of the optical system increases. The requirement of accurate focusing is compounded by the fact the optimal focal position and the depth of focus of various positions or areas of the lens or optical system may vary with respect to other positions or areas thus further complicating the task of trying to obtain optimum focal distance of the wafer from the lens or optical system. It thus becomes increasingly critical to precisely determine these characteristics at various positions or locations on the lens or optical system. Even further complicating the task is the necessity to test or "characterize" the lens system after it is installed as a part of the microlithographic system as a whole thus limiting the nature of test tools that can be used.

In the past, the focal position or "optimum focal distance" in this type of system has generally been determined by qualitative evaluations performed by trained technicians. While the precise techniques vary slightly they involve a trained operator looking at a series of lines, or other shapes exposed at various focal distances to determine which images appear to be the "sharpest" or "clearest." These images are taken at various locations on the optical system, and by repeatedly looking at and qualitatively evaluating such images, the technicians "decide" which images are the best, according to their judgement. One variation of such a technique is described in "Research Disclosures," April, 1986, Number 264, Disclosure Number 26,433, published by Kenneth Mason Publications, Ltd., England.

For certain types of lens systems, forms of quantative evaluation have been suggested; e.g. in U.S. Patent 4,435,079, dated March 6, 1984, and entitled "Apparatus for Testing Lenses by Determining Best Focus," a system is described wherein the intensity of PIXEL signals is measured at various locations and focal distances of a lens and those exceeding a certain magnitude are counted. This gives an indication of best focus, but has several drawbacks. First, expensive precision equipment is required, having complicated electronic circuits. Because of this and other factors, it is not suited to test a lens system in place in a lense system for a photolithographic tool. Another tool for evaluating lenses using photo diodes is shown in U.S Patent 4,585,342, dated April 29, 1986, entitled "System for Real-Time Monitoring the Characteristics, Variations and Alignment Errors of Lithography Structures." This also requires specialized equipment and gauges to determine received radiation.

According to the present invention, a method and apparatus are provided for determining the best focal position of any given location within the exposure field of an optical system, and preferably also for determining the focus surface or curvature of the optical system, and the relative depth of focus throughout the field. The invention utilizes a device hereafter referred to as a test vehicle having at least one object group having a large object and a small object, the small object having a size approximating the resolution limit of the optical system and the large object being significantly larger than said resolution limit. Preferably there is an array of object groups at spaced locations on the test vehicle corresponding to various locations of the optical system to be measured, the object groups being separated by substantial opaque regions. The test vehicle is set at a selected distance from an image sensor so as to allow the large image for each group to be sensed but not the small image. Thereafter, the image sensor is moved orthogonally with respect to the optical system and the focus distance of the optical system is changed and the image groups are again projected onto the image sensor. The orthogonal movement, the focus distance change and projecting steps are repeated successively until the large object and the small object of each group are sensed as images on the image sensor, and the orthogonal movements, change of focus and projecting steps are further repeated successively until only the large object of each group is sensed as an image and not the smaller object on the image sensor. This will produce a series of large object images and a series of small object images less in number than the series of large object images. The focal distance at the median point of the image series containing the small object image at each location represents the best focal position of that location of the optical system, and the number of small object images in any given series of small object images with respect to the number of small object images in any other small object image series represents the relative depth of focus therebetween.

One way of carrying out the invention is described in detail below with reference to drawings which illustrate only one specific embodiment, in which:
Figure 1 is a plan view of a test vehicle (not to scale) according to the invention;
Figure 1a is a detail view on an enlarged scale of one object group on the test vehicle;
Figure 2 is a representation (not to scale) of a series of images made from the test vehicle of Figure 1 according to this invention;
Figure 2a is a detail view on an enlarged scale of one series of images shown in Figure 2;
Figure 3 is a three-dimensional graphic reproduction of the focus surface of an optical system plotted from data derived from the image of Figure 2;
Figure 4 is a topographical plot of the focus depth variation plotted from date derived from the image of Figure 2; and
Figure 5 is a plan view of a wafer, showing in broken outline the approximate exposure area when the wafer is used as a sensor.

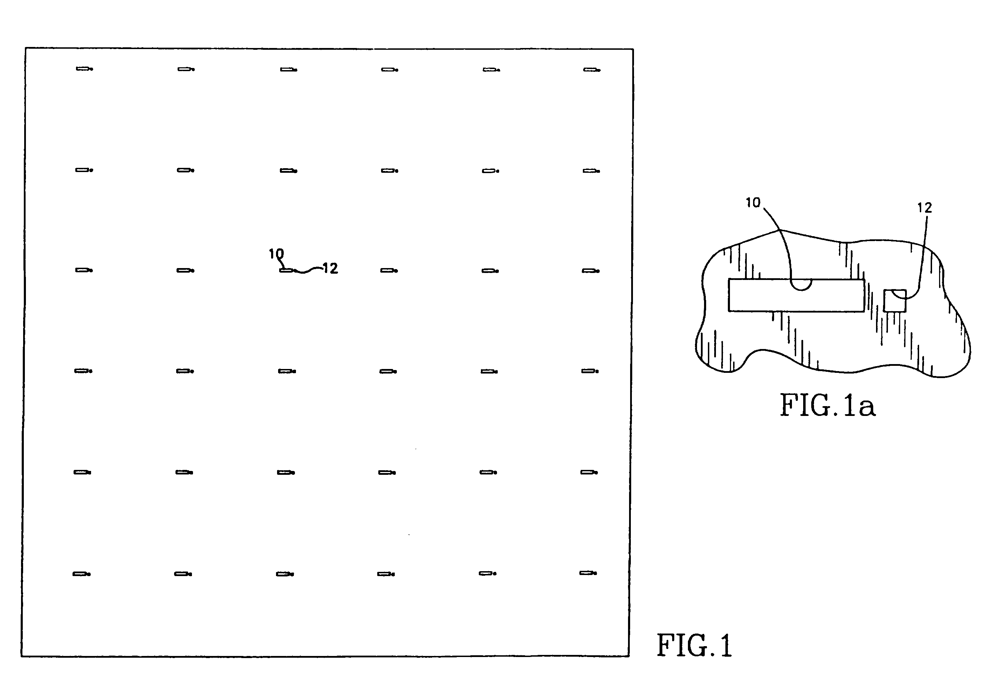

Referring now to the drawings, and for the present to Figure 1, a test vehicle for characterizing a lens or optical system on a step and repeat microlithography tool according to this invention is shown. While the invention finds uses in other optical systems, it is particularly adapted for use in step and repeat microlithographic tools such as a model 6000 manufactured by GCA Corp. In these tools, a mask or reticle is provided which has the desired pattern formed thereon which pattern is to be exposed on the wafer surface which has been coated with photo resist. The pattern is exposed onto a portion of the surface of the wafer through a lens or optical system, which reduces the pattern to the desired size. The wafer is then moved incrementally and another portion of the surface is exposed. This "step and repeat" is continued until the entire surface of the wafer has been exposed, after which the wafer surface is developed and processed in a conventional manner.

In this type of tool, it is necessary to have quite a precisely focused pattern on the wafer surface to provide satisfactory results, and to this end it is necessary to very carefully characterize the lens or optical system. In characterizing the lens or optical system, it is necessary to determine several parameters, one of the most important of which is the focal position, i.e. optimum or "best" focal position, of various locations in the field of the lens. This is necessary since even in the most precise optical system there is some variation of best focal position at various locations within the exposure field, the largest variations normally occurring around the edges or periphery of the field. It is also desirable to determine the relative depth of focus of various positions or areas of the field as well as the focus surface or curvature of the lens or optical system. The use of the test vehicle in conjunction with a wafer as an image sensor according to this invention allows the characterization of a lens or optical system as to focal position of various locations of the field as well as determining relative depth of focus of various locations within the field, and a determination of the focus surface or curvature of the field.

The test vehicle comprises an array of object groups, each group comprised of a large object 10 and a small object 12. The objects are actually openings in an opaque film such as a chrome layer on a glass plate which allow transmission of light or other energy therethrough. The object groups are separated from each other by substantial opaque regions. The object groups are also arranged in a pattern such that when the test vehicle is inserted into the path of the optical system, the image groups are located at different positions of the field such that they intercept not only the center of the lens or optical system, but also the intermediate and edge portions of the field. The small objects 12 which preferably are symmetrical have a dimension that is about equal to the resolution limit of the lens or optical system, and the large objects 10, which are preferably rectangles, have their smallest dimension significantly larger than the resolution limit of the lens or optical system. The resolution limit of microlithography tools is normally defined as that size which when exposed and developed will provide clear, sharp images in which all developed material will be removed. However, a size slightly smaller may actually be sensed and developed at least enough to be visually observable under a microscope. Hence, the term resolution limit as used herein is intended to include a size which can be visibly observed upon development, which may be slightly smaller than the rated resolution limit of the tool. Current microlithography tools, such as the GCA Model 6000, typically have a rated resolution limit of about 1.0 micron but an object as small as .8 micron can develop enough to be visually observed. Hence, the smaller object 12 should be about .8 micron square. The large object 10 can optimally be about 5x1.2 microns in size for the purpose of practicing this invention.

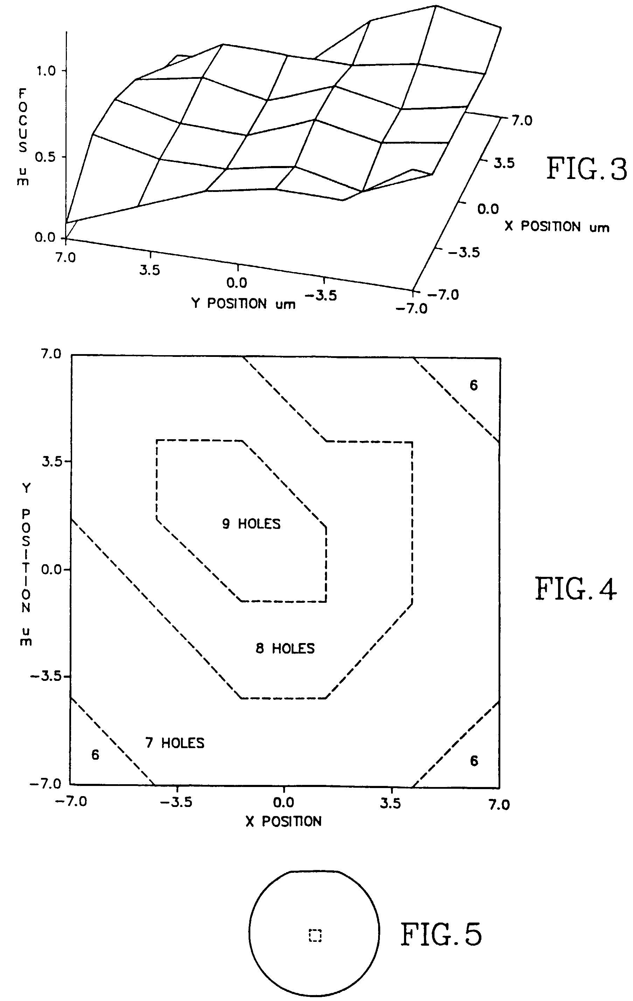

To utilize the test vehicle according to the invention, the test vehicle is inserted into the microlithography machine in the position where the reticle or mask resides. A conventional wafer of the type shown in Figure 5, having been conventionally prepared with photo resist is located at its normal position in the tool. Any one of a number of photo resist materials can be used, depending upon many factors including the light source, and light intensity. One particularly useful resist is AZ1350J, manufactured by Shipley Corp. The nominal focal distance of the tool is determined. This will normally be defined by the manufacturer, or can be calculated from the parameters of the optical or lens system, or can be roughly determined by routine experimentation. A typical optimum focal length for a GCA 6000 series machine is about 251 units. (Each unit is equal to 1/4 micron.) If this were exactly accurate for the entire surface of the lens or optical system and the focus system stable, then one could always use this setting and the best focus would be obtained. However, due to inherent variations within the exposure field and the instability of the focus system, the actual best focus for various locations on the lens or optical system may differ, and that is what this invention determines. To make this determination, the nominal or published best focus of the lens or optical system is determined. This is normally published by the manufacturer. However, if for some reason it is not available, it can be established by conventional techniques of repeated exposure and developing of objects having a size near the focal resolution limit of the lens or optical system changing the focal lengths by incremental amounts until an image is resolved. This is a well known technique.

Once the nominal focal length of the lens or optical system is determined, the focal length is changed (either shortened or lengthened) by a selected number of units on a tool. For example, on the GCA Model 6000, an initial change of an increase of 14 units is conventionally used. A portion of the wafer, corresponding to the size shown in broken outline in Figure 5, is then exposed through the test vehicle. The wafer is then moved orthogonally a very small distance. This distance should be about 2 times the dimension of the large object. This movement is not to be confused with the gross movement for step and repeat exposure in production of wafers, but is of a much smaller nature. The focal distance is then decreased. A typical change in focal distance is 0.25 micron. The wafer is then exposed again through the test vehicle. The wafer again is moved orthogonally, the focal distance decreased by 0.25 micron, and the wafer exposed again. This movement and change of focal distance is repeated a number of times each time the wafer is moved, and the focal distance shortened. Typically 13 to 15 exposures are made. If this step and expose sequence is followed, and fifteen exposures are made, the focal distance of the lens or optical system will have moved from 1.75 microns out of nominal best focus on one side through nominal best focus to 1.75 microns out of nominal best focus on the other side.

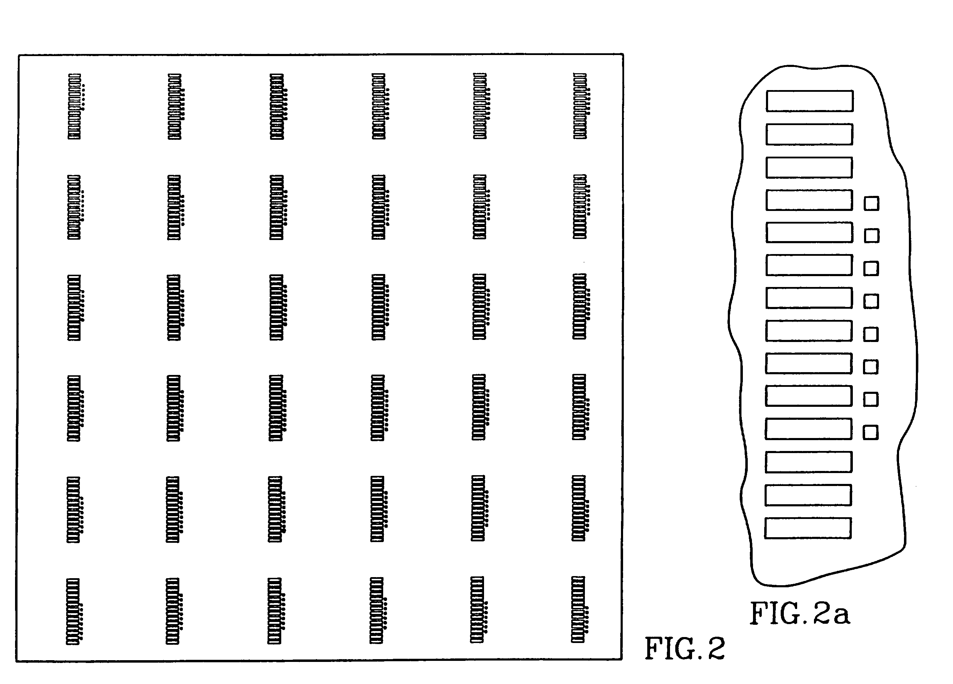

After all the exposures have been made, the photo resist on the wafer is developed in a conventional manner. (Shipley AZ2401 is a good developer for AZ1350J resist). At the location of each object group a seriesof images will be developed as shown in Figure 2 containing both large object images 14 and small object images 16. (These are permanent images that can be preserved and studied under a microscope.) These images will appear at each location as a series of large images 14, with a corresponding set of small images juxtaposed with respect to some of the large images. The reason that all of the large object images are developed, but only some of the small object images are developed, is that the large objects can be resolved by the lens or optical system and sensed on the wafer through a relatively large range of focal distances, whereas the smaller objects, which are close to the resolution limit of the lens or optical system can be resolved and printed on the wafer through a very small range of focal distances. Hence, at least one large object is resolved at the start of the sequence where a small object is not resolved, the sequence continues wherein both large and small objects are resolved, to a point when again only the large objects and not the small objects are resolved. The function of the large objects is to define the exact setting wherein the exposure started. If only small objects were used, one could not tell at which focal distance the objects were first resolved. Other techniques for identifying which small objects are resolved without the use of a large object are also possible. For example, the small objects could be exposed in some definitive pattern, such as a circle such that any 2 or more small objects resolved would have a unique relationship to each other, and thus identify where in the sequence of exposures they occurred.

One of the benefits of the present invention over prior art techniques is that with this invention the entire series of images at each given location of the exposure field can be viewed simultaneously, and the count made. With prior art techniques, each exposure of the object pattern has to be viewed separately, so the operator does not have a series of exposed object images in view simultaneously, but must view them serriatum, and try to remember their characteristics from one view to another and make subjective judgemental comparisons.

The best focus distance for the locations on the lens or optical system represented by each series of images is the mid-point, or median point, of the series of small object images. As can be seen in Figure 2a, the best focus setting for the location represented by that series of images is 240 units on the instrument scale; i.e. four small objects were resolved at settings closer than 240 units, and four small objects were resolved at settings greater than 240 units. Hence there is no qualitative judgement or comparison required by an operator. The operator or technician doing the evaluation need only count the number of small objects resolved on the wafer at each location and the mid-point of the number represents the best focus for that location. As can be seen in Figure 2, the best focus position of 36 different locations on a lens system can be determined utilizing this particular test vehicle. This information can be graphed then to show the focus surface or curvature of the lens or optical system as shown in Figure 3. Another advantage of the technique according to this invention over that of the prior art, is that the entire method is carried out within a very small area of the wafer (as shown in Figure 5), rather than over the entire wafer surface; and the less area involved, the less chance there is of wafer surface and resist film variations.

The series of images also can be used to determine the relative depth of focus variation of the exposure field at the various locations. The relative depth of focus of any location with respect to any other is the ratio between the number of small object images resolved at one location with respect to the number of small object images resolved at the other location. Thus the relative depth of focus of a location in which 7 small object images are resolved to that where 8 small object images are resolved is 7/8 or .875. A graph of focus depth variation of the lens system based on the resolution shown in Figure 2 is shown in Figure 4. In this Figure, a topographical "map" is shown representing those positions in the field where 6, 7, 8, and 9 small objects are resolved.

If it should happen that when the wafer is developed after 15 exposures as described above, there are some series where only large object images are not resolved on both sides of where large and small object images are resolved, the process can be repeated with some adjustments. It may be sufficient to change the starting point distance of the lens or optical system from the wafer, based on the patterns of images, or it may be necessary to either increase the incremental changes in focal length or add to the number of exposures in the series. In any event, minor experimentation will yield a series of object images patterns which can be used to quantitatively determine best focus position of various locations of a lens or optical system, as well as determining the relative depth of focus of the positions and to determine the focus surface or curvature of the lens or optical system.

While the invention has been described using 36 object groups, more or less can be used as needed. In fact, just a single object group in some cases may be sufficient if only one location is characterized.

## Claims

1. A method of quantitatively characterizing an optical system, comprising the steps of providing a test device having at least one object group thereon, each object group having a large object (10) and a small object (12) allowing transmission of light or other optical energy therethrough, said small object having a size of approximately the resolution limit of the optical system, said large object being of a size significantly larger than the resolution limit of the optical system, projecting an image of said object group through the optical system onto an image sensor with the optical system located at a preselected distance from the image sensor such as to allow the larger image to be sensed as an image but the smaller image not to be sensed, thereafter orthogonally displacing said image sensor with respect to the optical axis of said optical system and changing the focus of the optical system and then projecting the object group onto said sensor at the changed location, repeating the orthogonal displacement and change of focus and projection steps until both the small object and the large object in the group are sensed as images by the image sensor, continuing to repeat the orthogonal moves and changes of focus and projection steps successively until the larger object is sensed as an image, and the small object is not sensed by the image sensor to thus provide a series of images from each group starting with the image of a large object only progressing through images of large and small objects to an image of a large object only, whereby the focus at the median point of the image series of each group containing the small objects represents the best focus of that portion of the optical system.

2. The method as defined in claim 1, wherein an array of object groups is provided at spaced locations corresponding to various locations of the focus surface of the optical system, said object groups being separated by substantial opaque regions, whereby the number of small images sensed in a given series with respect to the number of small images sensed in any other series represents the relative depth of focus therebetween.

3. The method as defined in claim 1 or 2, wherein the small object (12) is symmetrical.

4. The method as defined in one or more of the preceding claims, wherein the orthogonal movement is directed to produce a side-by-side juxtaposed series of large object images and small object images.

5. A method of quantitatively characterizing an optical system, comprising the steps of providing a test device having at least one small object thereon allowing transmission of light or other optical energy therethrough, said small object having a size approximately the resolution limit of the optical system, projecting said object on an image sensor with the image sensor located at a focus which will not resolve the object as an image, thereafter orthogonally displacing said sensor with respect to an optical axis of the optical system and changing the focus and then projecting the object as an image on the image sensor at the changed location, repeating the orthogonal displacement, and change of focus, and projection steps until the small object is sensed as an image on the image sensor to thus provide a series of images, continuing to repeat the orthogonal moves and changes of focus and projecting steps successively until the small object is not sensed by the image sensor and determining the focus at which each small object iamge is resolved, whereby the focus at the median point of each series of small object images represents the best focus position of that portion of the optical system, wherein the small object or objects are exposed in some definitive pattern such that any two or more small objects resolved have a unique relationship to each other.

6. The method as defined in one or more of the preceding claims, wherein the image sensor includes photosensitive material.

7. The method as defined in claim 6, wherein the photosensitive material is developed to produce a permanent image pattern.

8. A test device for use in determining the best focus of an optical system, the focus surface or curvature of the optical system and the relative depth of focus throughout the field of said optical system, comprising an array of object groups for projection onto an image sensor, arranged at spaced locations on a substrate of said test device corresponding to various positions of the focus surface of the exposure field at the optical system to be measured, each object group comprising a large object (10) and a small object (12), said small object having a size of 0.8 micron square, which is approximately the resolution limit of the optical system to be measured and said large object having a size of 5 x 1.2 microns, which is significantly larger than said resolution limit, said object groups being separated by substantially opaque regions.

## Patentansprüche

1. Verfahren zur quantitativen Charakterisierung eines optischen Systems, umfassend die Schritte des Bereitstellens einer Prüfeinrichtung mit wenigstens einer darauf befindlichen Objektgruppe, wobei jede Objektgruppe ein großes Objekt (10) und ein kleines Objekt (12) aufweist, welche die Transmission von Licht oder einer anderen optischen Energie durch dieselben hindurch erlauben, wobei das kleine Objekt eine Abmessung von ungefähr der Auflösungsgrenze des optischen Systems besitzt und das große Objekt von einer Abmessung ist, die signifikant größer als die Auflösungsgrenze des optischen Systems ist, Projizierens eines Bildes der Objektgruppe durch das optische System auf einen Bildsensor, wobei sich das optische System in einem vorgewählten Abstand von dem Bildsensor befindet, derart, daß es möglich ist, das größere Bild als ein Bild zu erfassen, jedoch das kleinere Bild nicht zu erfassen, orthogonalen Verschiebens des Bildsensors bezüglich der optischen Achse des optischen Systems und Ändern des Fokus des optischen Systems und Projizierens der Objektgruppe auf den Sensor an der geänderten Stelle, Wiederholens der orthogonalen Verschiebung und der Änderung des Fokus und der Projektionsschritte, bis sowohl das kleine Objekt als auch das große Objekt in der Gruppe durch den Bildsensor als Bilder erfaßt werden, Fortsetzens der Wiederholung der orthogonalen Bewegungen und der Änderungen des Fokus und der Projektionsschritte sukzessive, bis durch den Bildsensor das größere Objekt als ein Bild erfaßt und das kleine Objekt nicht erfaßt wird, um so eine Serie von Bildern von jeder Gruppe, beginnend mit dem Bild eines großen Objektes, lediglich mittels Fortschreiten durch Bilder von großen und kleinen Objekten bis zu einem Bild nur eines großen Objektes bereitzustellen, wodurch der Fokus am mittleren Punkt der Bildserie jeder Gruppe, welche die kleinen Objekte enthält, den besten Fokus jenes Bereichs des optischen Systems darstellt.

2. Verfahren, wie in Anspruch 1 definiert, wobei eine regelmäßige Anordnung von Objektgruppen an voneinander beabstandeten Stellen entsprechend verschiedenen Stellen der Brennebene des optischen Systems bereitgestellt wird, wobei die Objektgruppen durch im wesentlichen undurchlässige Bereiche getrennt sind, wodurch die Anzahl von kleinen Bildern, die in einer gegebenen Serie erfaßt wird, in bezug auf die Anzahl von kleinen Bildern, die in jeder anderen Serie erfaßt wird, die dazwischenliegende relative Tiefenschärfe darstellt.

3. Verfahren, wie in Anspruch 1 oder 2 definiert, wobei das kleine Objekt (12) symmetrisch ist.

4. Verfahren, wie in einem oder mehreren der vorhergehenden Ansprüche definiert, wobei die orthogonale Bewegung darauf abzielt, eine Seite-an-Seite aneinandergrenzende Serie von Bildern großer Objekte und von Bildern kleiner Objekte zu erzeugen.

5. Verfahren zur quantitativen Charakterisierung eines optischen Systems, umfassend die Schritte des Bereitstellens einer Prüfeinrichtung mit wenigstens einem darauf befindlichen kleinen Objekt, das die Transmission von Licht oder einer anderen optischen Energie durch dasselbe hindurch erlaubt, wobei das kleine Objekt eine Abmessung von ungefähr der Auflösungsgrenze des optischen Systems besitzt, Projizierens des Objektes auf einen Bildsensor, wobei sich der Bildsensor in einem Fokus befindet, der das Objekt nicht als ein Bild auflöst, orthogonalen Verschiebens des Sensors bezüglich einer optischen Achse des optischen Systems und Ändern des Fokus und Projizierens des Objektes als ein Bild auf den Bildsensor an der geänderten Stelle, Wiederholens der orthogonalen Verschiebung und der Änderung des Fokus und der Projektionsschritte, bis das kleine Objekt auf dem Bildsensor als ein Bild erfaßt wird, um so eine Serie von Bildern bereitzustellen, Fortsetzens der Wiederholung der orthogonalen Bewegungen und der Änderungen des Fokus und der Projektionsschritte sukzessive, bis das kleine Objekt durch den Bildsensor nicht mehr erfaßt wird, und Bestimmens des Fokus, bei dem jedes Bild des kleinen Objektes aufgelöst wird, wodurch der Fokus an dem mittleren Punkt jeder Serie von Bildern kleiner Objekte die beste Fokusposition jenes Bereichs des optischen Systems darstellt, wobei das -kleine Objekt oder die kleinen Objekte in irgendeinem bestimmten Muster derart belichtet werden, daß jeweils zwei oder mehr aufgelöste kleine Objekte eine eindeutige Beziehung zueinander aufweisen.

6. Verfahren, wie in einem oder mehreren der vorhergehenden Ansprüche definiert, wobei der Bildsensor photosensitives Material beinhaltet.

7. Verfahren, wie in Anspruch 6 definiert, wobei das photosensitive Material entwickelt wird, um ein permanentes Bildmuster zu erzeugen.

8. Prüfeinrichtung zur Verwendung bei der Bestimmung des besten Fokus eines optischen Systems, der Brennebene oder Krümmung des optischen Systems und der relativen Tiefenschärfe über das Feld des optischen Systems hinweg, die eine regelmäßige Anordnung von Objektgruppen zur Projektion auf einen Bildsensor beinhaltet, die an voneinander beabstandeten Stellen auf einem Träger der Prüfeinrichtung entsprechend verschiedenen Positionen der Brennebene des Belichtungsfeldes an dem zu vermessenden optischen System angeordnet sind, wobei jede Objektgruppe ein großes Objekt (10) und ein kleines Objekt (12) beinhaltet, wobei das kleine Objekt eine Abmessung von 0,8 Quadratmikrometer besitzt, was ungefähr der Auflösungsgrenze des zu vermessenden optischen Systems entspricht, und das große Objekt eine Abmessung von 5 x 1,2 Mikrometer aufweist, was beträchtlich größer als die Auflösungsgrenze ist, wobei die Objektgruppen durch im wesentlichen undurchlässige Bereiche getrennt sind.

## Revendications

1. Procédé pour caractériser quantitativement un système optique, comprenant les étapes consistant à :
prévoir un dispositif d'essai sur lequel se trouve au moins un groupe d'objets, chaque groupe d'objets comprenant un objet de grande taille (10) et un objet de petite taille (12) à travers lesquels de la lumière ou une autre forme d'énergie optique peut être transmise, la taille du dit objet de petite taille correspondant approximativement à la limite de résolution du système optique, ledit objet de grande taille étant d'une taille sensiblement plus grande que la limite de définition du système optique ;
projeter une image du dit groupe d'objets sur un capteur d'images à travers le système optique, ledit système optique étant positionné à une distance prédéterminée du capteur d'images de façon à ce que l'image la plus grande puisse être captée sous forme d'image, mais pas l'image la plus petite ;
ensuite, déplacer orthogonalement ledit capteur d'images par rapport à l'axe optique du dit système optique et modifier la distance focale du système optique avant de projeter le groupe d'objets sur ledit capteur à sa nouvelle position ;
répéter les étapes de déplacement orthogonal, de modification de distance focale et de projection jusqu'à ce que l'objet de petite taille et l'objet de grande taille du groupe soient captés sous forme d'images par le capteur d'images ;
continuer à répéter les étapes de déplacement orthogonal, de la distance focale et de projection successivement jusqu'à ce que l'objet de grande taille soit capté sous forme d'image par le capteur d'images, mais pas l'objet de petite taille, pour produire ainsi une série d'images pour chaque groupe commençant par l'image d'un objet de grande taille uniquement et progressant, via des images d'objets de grande taille et de petite taille, jusqu'à l'image d'un objet de grande taille uniquement, la distance focale au point médian de la série d'images de chaque groupe contenant les objets de petite taille représentant la meilleure distance focale pour cette partie du système optique.

2. Procédé selon la revendication 1, où une matrice de groupes d'objets est prévue sur des positions espacées correspondant aux différents emplacements de la surface de focalisation du système optique, les dits groupes d'objets étant séparés par des zones en grande partie opaques, caractérisé en ce que le nombre d'images de petite taille captées dans une série donnée par rapport au nombre d'images de petite taille captées dans une autre série représente la profondeur de champ ou la différence focale relative entre celles-ci.

3. Procédé selon la revendication 1 ou 2, où l'objet de petite taille (12) est symétrique.

4. Procédé selon une ou plusieurs des revendications précédentes, où le déplacement orthogonal vise à produire une série d'images d'objets de grande taille et d'images d'objets de petite taille juxtaposées côte-à-côte.

5. Procédé pour caractériser quantitavement un système optique, comprenant les étapes consistant à :
prévoir un dispositif d'essai sur lequel se trouve au moins un objet de petite taille à travers lequel de la lumière ou une autre forme d'énergie optique peut être transmise, la taille du dit objet de petite taille correspondant approximativement à la limite de définition du système optique ;
projeter ledit objet sur un capteur d'images, le capteur d'images étant situé à une distance focale qui ne permet pas de résoudre l'objet sous forme d'image ;
ensuite, déplacer orthogonalement ledit capteur d'images par rapport à l'axe optique du dit système optique et modifier la distance focale du système optique avant de projeter l'objet sous forme d'image sur ledit capteur à sa nouvelle position ;
répéter les étapes de déplacement orthogonal, de modification de la distance focale et de projection jusqu'à ce que l'objet de petite taille soit capté sous forme d'image par le capteur d'images pour produire ainsi une série d'images ;
continuer à répéter les étapes de déplacement orthogonal, de modification de la distance focale et de projection successivement jusqu'à ce que l'objet de petite taille ne soit plus capté par le capteur d'images et déterminer la distance focale à laquelle chaque image d'objet de petite taille est résolue, la distance focale au point médian de chaque série d'images de petite taille représentant la meilleure position focale pour cette partie du système optique ;
caractérisé en ce que l'objet ou les objets de petite taille sont exposés selon une configuration définitive telle que les objets de toute pluralité d'objets de petite taille résolus aient une relation spécifique entre eux.

6. Procédé selon une ou plusieurs des revendications précédentes, où le capteur d'images comprend un corps photosensible.

7. Procédé selon la revendication 6, où le corps photosensible est développé pour produire une image permanente.

8. Dispositif d'essai utilisé pour déterminer la meilleure distance focale d'un système optique, la surface ou la courbure de focalisation du système optique et la différence focale relative sur le champ du dit système optique, ledit dispositif comprenant une matrice de groupes d'objets pour projection sur un capteur d'images disposée sur des positions espacées sur un substrat du dit dispositif d'essai correspondant à différentes positions de la surface de focalisation du champ d'exposition du système à optique à mesurer, chaque groupe d'objets comprenant un objet de grande taille (10) et un objet de petite taille (12), ledit objet de petite ayant une dimension de 0,8 microns carrés, qui correspond approximativement à la limite de résolution du système optique à mesurer, et ledit objet de grande taille ayant une dimension de 5 x 1,2 microns, qui est sensiblement plus grande que ladite limite de résolution, les dits groupes d'objets étant séparés par des zones en grande partie opaques.
